# EUROPÄISCHE PATENTSCHRIFT

(11) **EP 2 493 276 B1**
(45) Veröffentlichungstag und Bekanntmachung des Hinweises auf die Patenterteilung: **18.09.2013**
(21) Anmeldenummer: 12150882.4
(22) Anmeldetag: 12.01.2012
(51) Int. Cl.: H05K 7/14, H05K 5/00

(54) **Schaltungsanordnung**
Switching assembly
Agencement de circuit

(30) Priorität: 22.02.2011 DE 102011004491
(43) Veröffentlichungstag der Anmeldung: 29.08.2012
(73) Patentinhaber: SEMIKRON Elektronik GmbH & Co. KG, 90431 Nürnberg (DE)
(72) Erfinder: Popp, Rainer, 91580 Petersaurach (DE); Walter, Christian, 91522 Ansbach (DE)

(56) Entgegenhaltungen:
- EP-A2- 1 150 555
- EP-A2- 1 978 557
- DE-A1-102007 051 716
- DE-A1-102008 057 831
- DE-U1- 9 201 258
- US-A- 5 774 353

## Beschreibung

Die Erfindung betrifft eine Schaltungsanordnung mit mindestens einem Leistungshalbleitermodul und mit einer Treibereinrichtung, die in einem Gehäuse eine Treiberleiterplatte aufweist, wobei das Gehäuse einen Gehäuserahmen und einen Gehäusedeckel aufweist.

Eine derartige Schaltungsanordnung ist aus der DE 10 2008 057 831 A1 bekannt. Bei dieser bekannten Schaltungsanordnung ist die Treiberleiterplatte im Gehäuse mittels einer Anzahl Befestigungselemente lateral beweglich vorgesehen. Die Befestigungselemente sind von Befestigungsschrauben gebildet. Soll eine solche bekannte Schaltungsanordnung beispielhaft mit mindestens einem Glasfaserkabel kombiniert werden, so ist auf dem Gehäusedeckel eine Aufsatzeinrichtung zu befestigen, wobei die genannten Befestigungsschrauben verlängert sein müssen, um die Aufsatzeinrichtung mit dem Gehäusedeckel zu verschrauben.

Wenn eine derartige, mit einer Aufsatzeinrichtung kombinierte Schaltungsanordnung im Bedarfsfall demontiert werden soll, ist es erforderlich, die Befestigungsschrauben zu lösen, so dass nicht nur die Aufsatzeinrichtung vom Gehäusedeckel sondern gleichzeitig auch das Gehäuse geöffnet wird. Das stellt einen nicht zu vernachlässigenden Mangel dar.

In Kenntnis dieser Gegebenheiten liegt der Erfindung die Aufgabe zugrunde, eine Schaltungsanordnung der eingangs genannten Art zu schaffen, die einfach ausgebildet ist und bei welcher im Bedarfsfall eine Demontage der Aufsatzeinrichtung vom Gehäusedecke des Gehäuses einfach möglich ist, ohne gleichzeitig das Gehäuse der Schaltungsanordnung zu öffnen.

Diese Aufgabe wird erfindungsgemäß durch die Merkmale des Anspruches 1, d.h. dadurch gelöst, dass auf dem Gehäusedeckel eine Aufsatzeinrichtung vorgesehen ist, die ein Unterteil und ein mit dem Unterteil verschraubtes Oberteil aufweist, wobei zwischen dem Unterteil und dem Oberteil mindestens eine Elektronikplatine vorgesehen ist, das Unterteil einen Grundrahmen aufweist, von dem federnde Rastelemente wegstehen, die in zugehörige Rastlöcher einrastbar sind, die im Gehäusedeckel ausgebildet sind, und das Oberteil der Aufsatzeinrichtung mit zu den Rastelementen des Unterteils zugeordneten Verriegelungselementen ausgebildet ist, die in die Rastlöcher des Gehäusedeckels hineinstehen und die Rastelemente in den Rastlöchern unbeweglich festlegen.

Bei der erfindungsgemäßen Schaltungsanordnung ist nur das Unterteil mit dem Oberteil der Aufsatzeinrichtung verschraubt. Die Aufsatzeinrichtung ist mit dem Gehäusedeckel der Schaltungsanordnung verrastet, d.h. mittels den federnden Rastelementen und den Verriegelungselementen formschlüssig verbunden. Die Befestigungsschrauben können also vergleichsweise kurz sein.

Zur Demontage ist es nur erforderlich, das Oberteil der Aufsatzeinrichtung vom Unterteil loszuschrauben und das Oberteil vom Unterteil zu entfernen. Danach kann auch das Unterteil vom Gehäusedeckel problemlos entfernt werden, indem die federnden Rastelemente aus den im Gehäusedeckel ausgebildeten Rastlöchern entfernt werden. Das Gehäuse der Schaltungsanordnung braucht also bei der Demontage in vorteilhafter Weise nicht geöffnet zu werden.

Bei der erfindungsgemäßen Schaltungsanordnung weist die mindestens eine Elektronikplatine der Aufsatzeinrichtung zweckmäßigerweise eine Anschlußeinrichtung für mindestens ein Glasfaserkabel und eine Schaltungseinrichtung zur Umwandlung optischer Lichtsignale in elektrische Signale auf. Die Schaltungseinrichtung weist beispielhaft einen Empfänger für die optischen Lichtsignale auf, die dann in elektrische Signale umgewandelt werden.

An der in der Aufsatzeinrichtung vorgesehenen Elektronikplatine ist vorzugsweise mindestens eine Ausgangsanschlußeinrichtung für die elektrischen Signale angebracht. Die mindestens eine Ausgangsanschlußeinrichtung ist mit der im Gehäuse der Schaltungsanordnung vorgesehenen Treiberleiterplatte zusammengeschaltet. Zu diesem Zwecke kann der Gehäusedeckel mit einer Öffnung für eine Verbindungseinrichtung ausgebildet sein, die zur elektrischen Verbindung der Treiberleiterplatte mit der mindestens einen Ausgangsanschlußeinrichtung der Elektronikplatine vorgesehen ist.

Die erfindungsgemäße Schaltungsanordnung weist den Vorteil auf, dass sie gegen Schock- und Vibrationsbelastungen geschützt ist. Außerdem besteht ein Staubschutz. Desgleichen ist ein Berührungsschutz gegeben, so dass Beschädigungen empfindlicher Komponenten der Schaltungsanordnung durch ein ungewolltes Öffnen des Gehäuses der Schaltungsanordnung verhindert werden.

Weitere Einzelheiten, Merkmale und Vorteile ergeben sich aus der nachfolgenden Beschreibung eines in der Zeichnung dargestellten Ausführungsbeispieles der erfindungsgemäßen Schaltungsanordnung.

Es zeigen:
Figur 1 eine perspektivische Ansicht der Schaltungsanordnung - ohne die zugehörige Aufsatzeinrichtung - mit drei nebeneinander angeordneten Leistungshalbleitermodulen und einer gemeinsamen Treibereinrichtung,
Figur 2 eine aufgeschnittene dreidimensionale Ansicht des Gehäusedeckels der Schaltungsanordnung mit der auf dem Gehäusedeckel angebrachten Aufsatzeinrichtung, und
Figur 3 eine Schnittansicht der Schaltungsanordnung mit einem der Leistungshalbleitermodule, der zugehörigen Treibereinrichtung für die Leistungshalbleitermodule 12 sowie der auf dem Gehäusedeckel angebrachten Aufsatzeinrichtung.

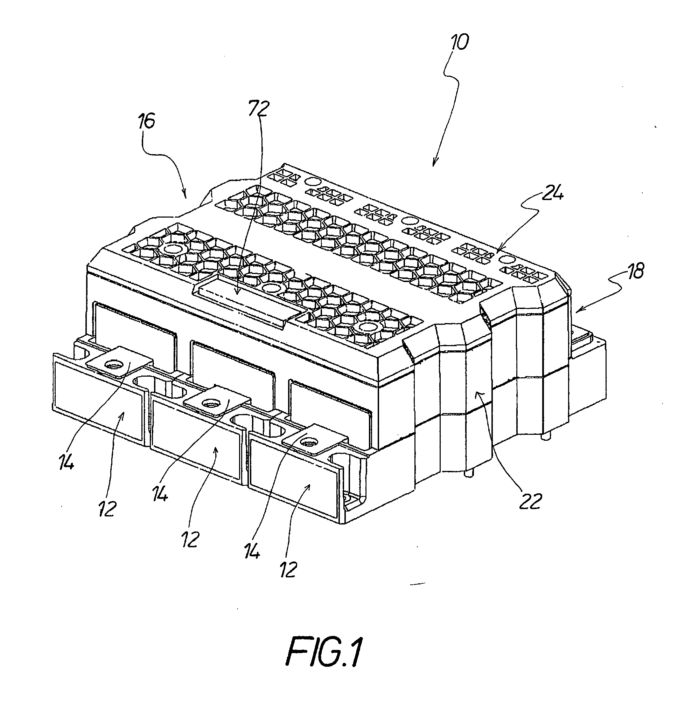

Figur 1 zeigt eine Ausbildung der Schaltungsanordnung 10 mit drei Leistungshalbleitermodulen 12, deren Wechselspannungsanschlüsse mit der Bezugziffer 14 bezeichnet sind.

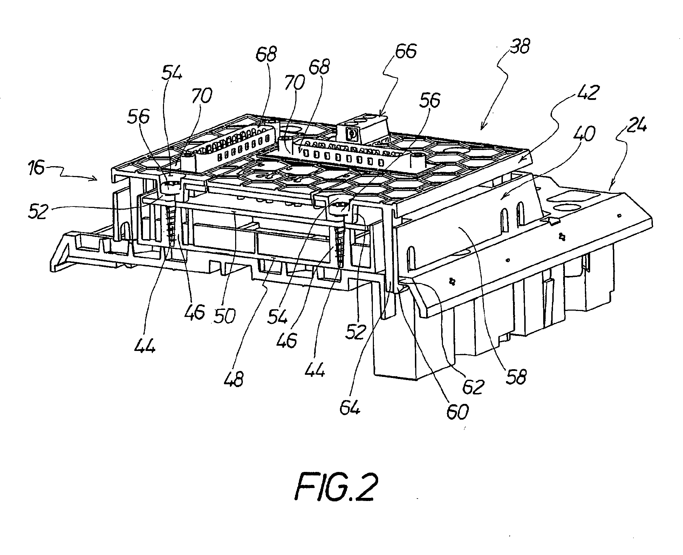

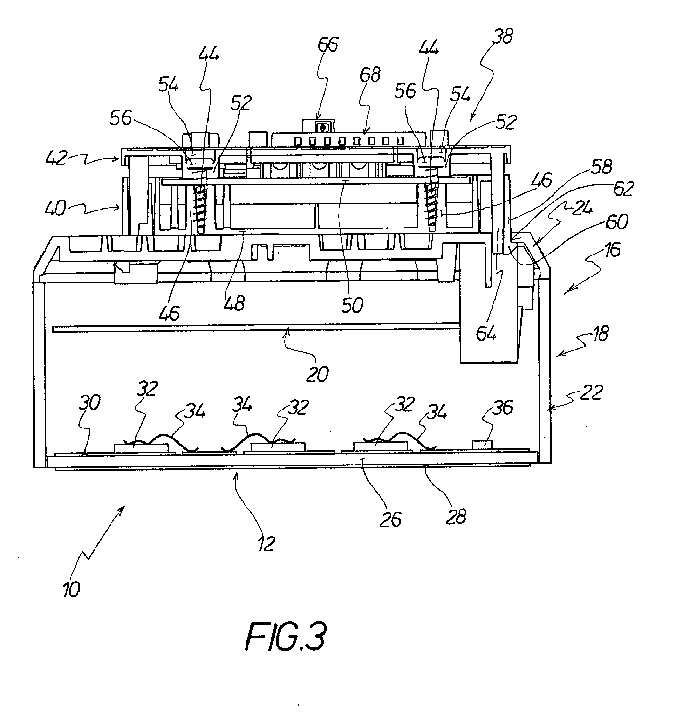

Die Leistungshalbleitermodule 12 weisen eine gemeinsame Treibereinrichtung 16 auf, die in einem Gehäuse 18 eine Treiberleiterplatte 20 aufweist (siehe die Figuren 2 und 3). Wie aus Figur 3 ersichtlich ist, weist das Gehäuse 18 einen Gehäuserahmen 22 und einen Gehäusedeckel 24 auf. Mit der Bezugsziffer 12 ist auch in Figur 3 ein Leistungshalbleitermodul bezeichnet, der einen Isolierstoffkörper 26 bspw. aus einer Industriekeramik wie Al₂O₃ o.dgl. aufweist, der an einer Hauptfläche mit einer vollflächigen Metallschicht 28 und an der davon abgewandten, in das Innere des Gehäuses 18 weisenden Hauptfläche mit einer Leiterbahnen bildenden schaltstrukturierten Metallschicht 30 versehen ist. Mit der Bezugsziffer 32 sind Leistungshalbleiterbauelemente bezeichnet, die mittels Bonddrähten 34 mit der schaltstrukturierten Metallschicht 30 zusammengeschaltet sind. Mit der Bezugsziffer 36 ist ein an der schaltstrukturierten Metallschicht 30 angeordnetes Sensorbauelement bezeichnet.

Wie aus den Figuren 2 und 3 ersichtlich ist, ist auf dem Gehäusedeckel 24 eine Aufsatzeinrichtung 38 angeordnet, die ein Unterteil 40 und ein Oberteil 42 aufweist. Das Oberteil 42 ist mit dem Unterteil 40 mittels Befestigungsschrauben 44 verschraubt. Das Unterteil 40 ist mit Ansätzen 46 ausgebildet, in welche die Befestigungsschrauben 44 bspw. selbstschneidend eingeschraubt sind. Die Ansätze 46 stehen von einem Boden 48 des Unterteiles 40 materialeinstückig nach oben. Die Ansätze 46 dienen zur Lagerung einer Elektronikplatine 50, die im zusammengebauten Zustand der Aufsatzeinrichtung 38 zwischen dem Unterteil 40 und dem Oberteil 42 eingeklemmt ist. Zu diesem Zwecke ist das Oberteil 42 mit Noppen 52 ausgebildet, die den Ansätzen 46 des Unterteiles 40 zugeordnet und zugewandt sind. Die Noppen 52 sind außenseitig mit Vertiefungen 54 ausgebildet, die zur Aufnahme der Schraubköpfe 56 der Befestigungsschrauben 44 vorgesehen sind.

Im zusammengebauten Zustand der Aufsatzeinrichtung 38 erstrecken sich die Befestigungsschrauben 44 durch Löcher hindurch, die in der Elektronikplatine 50 der Aufsatzeinrichtung 38 ausgebildet sind.

Das Unterteil 40 der Aufsatzeinrichtung 38 weist einen Grundrahmen 58 auf, von dem federnde Rastelemente 60 nach unten ragen. Das Unterteil 40 ist mit den federnden Rastelementen 60 in zugehörige Rastlöcher 62 einrastbar bzw. eingerastet, die im Gehäusedeckel 24 der Schaltungsanordnung 10 ausgebildet sind.

Das Oberteil 42 der Aufsatzeinrichtung 38 ist materialeinstückig mit Verriegelungselementen 64 ausgebildet, die den federnden Rastelementen 60 des Unterteils 40 zugeordnet sind. Im zusammengebauten Zustand der Aufsatzeinrichtung 38 stehen die Verriegelungselemente 64 gemeinsam mit den federnden Rastelementen 60 in die zugehörigen Rastlöcher 62 des Gehäusedeckels 64 hinein, wobei die Verriegelungselemente 64 die federnden Rastelemente 60 in den Rastlöchern 62 lateral unbeweglich festlegen, so dass die Aufsatzeinrichtung 38 mit dem Gehäusedeckel 24 fest verbunden ist.

Zur Demontage der Aufsatzeinrichtung 38 vom Gehäusedeckel 24 ist es nur erforderlich, das Oberteil 42 vom Unterteil 40 loszuschrauben und das Oberteil 42 vom Unterteil 40 zu entfernen, wonach die federnden Rastelemente 60 aus den Rastlöchern 62 des Gehäusedeckels 24 entfernt werden können. Eine Öffnung des Gehäuses 18 der Schaltungsanordnung 10, d.h. eine Entfernung des Gehäusedeckels 24 vom Gehäuse 18 der Schaltungsanordnung 10 ist erfindungsgemäß nicht erforderlich.

Die Figur 2 verdeutlicht außerdem eine Anschlußeinrichtung 66 für mindestens ein (nicht gezeichnetes) Glasfaserkabel. Die Anschlußeinrichtung 66 ist mit der Elektronikplatine 50 zusammengeschaltet. Die Elektronikplatine 50 weist in an sich bekannter Weise eine Schaltungseinrichtung zur Umwandlung optischer Lichtsignale in elektrische Signale sowie Ausgangsanschlußeinrichtungen 68 für die elektrischen Signale auf. Das Oberteil 42 der Aufsatzeinrichtung 38 ist mit Aussparungen 70 für die Ausgangsanschlußeinrichtungen 68 ausgebildet.

Der Gehäusedeckel 24 ist mit einer Öffnung 72 (siehe Figur 1) für eine nicht gezeichnete Verbindungseinrichtung ausgebildet, die zur Verbindung der Treiberleiterplatte 20 mit den Ausgangsanschlußeinrichtungen 68 der Aufsatzeinrichtung 38 vorgesehen ist.

### Bezugsziffernliste:

- 10: Schaltungsanordnung
- 12: Leistungshalbleitermodul (von 10)
- 14: Wechselspannungsanschluß (von 12)
- 16: Treibereinrichtung (von 10 für 12)
- 18: Gehäuse (von 10)
- 20: Treiberleiterplatte (in 18 für 16)
- 22: Gehäuserahmen (von 18)
- 24: Gehäusedeckel (von 18 für 22)
- 26: Isolierstoffkörper (von 12)
- 28: Metallschicht (an 26)
- 30: Metallschicht (an 26)
- 32: Leistungshalbleiterbauelement (an 30)
- 34: Bonddraht (zwischen 32 und 30)
- 36: Sensorbauelement (an 30)
- 38: Aufsatzeinrichtung (an 24)
- 40: Unterteil (von 38)
- 42: Oberteil (von 38)
- 44: Befestigungsschraube (für 40 und 42)
- 46: Ansatz (von 40 für 44)
- 48: Boden (von 40)
- 50: Elektronikplatine (von 38 zwischen 40 und 42)
- 52: Noppe (von 42 für 44)
- 54: Vertiefung (von 52 für 56)
- 56: Schraubkopf (von 44)
- 58: Grundrahmen (von 40)
- 60: federndes Rastelement (an 58)
- 62: Rastloch (in 24 für 60 und 64)
- 64: Verriegelungselement (an 42)
- 66: Anschlußeinrichtung (an 38 für 50)
- 68: Ausgangsanschlußeinrichtung (von 50 an 42)
- 70: Aussparung (in 42 für 68)
- 72: Öffnung (in 24)

## Patentansprüche

1. Schaltungsanordnung mit mindestens einem Leistungshalbleitermodul (12) und mit einer Treibereinrichtung (16), die in einem Gehäuse (18) mindestens eine Treiberleiterplatte (20) aufweist, wobei das Gehäuse (18) einen Gehäuserahmen (22) und einen Gehäusedeckel (24) aufweist,
**dadurch gekennzeichnet,**
**dass** auf dem Gehäusedeckel (24) eine Aufsatzeinrichtung (38) vorgesehen ist, die ein Unterteil (40) und ein mit dem Unterteil (40) verschraubtes Oberteil (42) aufweist, wobei zwischen dem Unterteil (40) und dem Oberteil (42) mindestens eine Elektronikplatine (50) vorgesehen ist und von einem Grundrahmen (58) des Unterteils (40) federnde Rastelemente (60) wegstehen, die in zugehörige Rastlöcher (62) einrastbar sind, die im Gehäusedeckel (24) ausgebildet sind, und wobei das Oberteil (42) mit zu den Rastelementen (60) des Unterteils (40) zugeordneten Verriegelungselementen (64) ausgebildet ist, die in die Rastlöcher (62) des Gehäusedeckels (24) hineinstehen und die Rastelemente (60) in den Rastlöchern (62) lateral unbeweglich festlegen.

2. Schaltungsanordnung nach Anspruch 1,
**dadurch gekennzeichnet,**
**dass** die mindestens eine Elektronikplatine (50) eine Anschlußeinrichtung (66) für mindestens ein Glasfaserkabel und eine Schaltungseinrichtung zur Umwandlung optischer Lichtsignale in elektrische Signale aufweist.

3. Schaltungsanordnung nach Anspruch 2,
**dadurch gekennzeichnet,**
**dass** die Elektronikplatine (50) mit mindestens einer Ausgangsanschlußeinrichtung (66) für die elektrischen Signale versehen ist.

4. Schaltungsanordnung nach Anspruch 3,
**dadurch gekennzeichnet,**
**dass** das Oberteil (42) der Aufsatzeinrichtung (38) mit einer Aussparung (70) für die mindestens eine Ausgangsanschlußeinrichtung (68) ausgebildet ist.

5. Schaltungsanordnung nach Anspruch 3,
**dadurch gekennzeichnet,**
**dass** der Gehäusedeckel (24) mit einer Öffnung (72) für eine Verbindungseinrichtung ausgebildet ist, die zur elektrischen Verbindung der Treiberleiterplatte (20) mit der mindestens einen Ausgangsanschlu βeinrichtung (68) der Elektronikplatine (50) vorgesehen ist.

## Claims

1. Circuit arrangement having at least one power semiconductor module (12) and having a driver device (16) which has at least one driver circuit board (20) in a housing (18), wherein the housing (18) has a housing frame (22) and a housing cover (24),
**characterised in that**
on the housing cover (24) is provided a top-mounted device (38) which has a lower portion (40) and an upper portion (42) screwed to the lower portion (40), wherein at least one circuit board (50) is provided between the lower portion (40) and the upper portion (42), and from a main frame (58) of the lower portion (40) protrude spring latch elements (60) which can be latched in associated latch holes (62) formed in the housing cover (24), and wherein the upper portion (42) is designed with locking elements (64) which are associated with the latch elements (60) of the lower portion (40) and which extend into the latch holes (62) in the housing cover (24) and fix the latch elements (60) in the latch holes (62) so that they are laterally immovable.

2. Circuit arrangement according to claim 1,
**characterised in that**
the at least one circuit board (50) has a terminal device (66) for at least one fibre optic cable and a switching device for converting optical light signals to electrical signals.

3. Circuit arrangement according to claim 2,
**characterised in that**
the circuit board (50) is provided with at least one output terminal device (66) for the electrical signals.

4. Circuit arrangement according to claim 3,
**characterised in that**
the upper portion (42) of the top-mounted device (38) is designed with a recess (70) for the at least one output terminal device (68).

5. Circuit arrangement according to claim 3,
**characterised in that**
the housing cover (24) is designed with an opening (72) for a connecting device which is provided for electrical connection of the driver circuit board (20) to the at least one output terminal device (68) of the circuit board (50).

## Revendications

1. Montage de circuit avec au moins un module semi-conducteur de puissance (12) et avec un dispositif de commande (16) comportant au moins une carte imprimée de commande (20) dans un boîtier (18), ledit boîtier (18) présentant un cadre de boîtier (22) et un couvercle de boîtier (24),
**caractérisé**
**en ce qu'**un dispositif de couverture (38) est prévu sur le couvercle de boîtier (24), lequel comporte une pièce inférieure (40) et une pièce supérieure (42) vissée sur la pièce inférieure (40), au moins une platine électronique (50) étant prévue entre la pièce inférieure (40) et la pièce supérieure (42), des éléments d'enclenchement (60) élastiques faisant saillie d'un cadre de base (58) de la pièce inférieure (40), lesquels sont enclenchables dans des trous d'enclenchement (62) correspondants ménagés dans le couvercle de boîtier (24), et la pièce supérieure (42) étant réalisée avec des éléments de verrouillage (64) associés aux éléments d'enclenchement (60) de la pièce inférieure (40), lesquels s'engagent dans les trous d'enclenchement (62) du couvercle de boîtier (24) et fixent en les immobilisant latéralement les éléments d'enclenchement (60) dans les trous d'enclenchement (62).

2. Montage de circuit selon la revendication 1,
**caractérisé**
**en ce que** la au moins une platine électronique (50) comporte un dispositif de connexion (66) pour au moins un câble en fibres de verre et un dispositif de commutation pour la conversion de signaux optiques lumineux en signaux électriques.

3. Montage de circuit selon la revendication 2,
**caractérisé**
**en ce que** la platine électronique (50) comporte au moins un dispositif de connexion de sortie (66) pour les signaux électriques.

4. Montage de circuit selon la revendication 3,
**caractérisé**
**en ce que** la pièce supérieure (42) du dispositif de couverture (38) est réalisée avec un évidement (70) pour le au moins un dispositif de connexion de sortie (68).

5. Montage de circuit selon la revendication 3,
**caractérisé**
**en ce que** le couvercle de boîtier (24) est réalisé avec une ouverture (72) pour un dispositif de branchement prévu pour la liaison électrique de la carte imprimée de commande (20) avec le au moins un dispositif de connexion de sortie (68) de la platine électronique (50).
